Europäisches Patentamt

European Patent Office

Office européen des brevets

(19)

(11) Publication number: **0 107 394**
**B1**

(12)    **EUROPEAN PATENT SPECIFICATION**

(45) Date of publication of patent specification: **18.05.88**

(51) Int. Cl.⁴: **G 11 C 11/40**, G 11 C 8/00

(21) Application number: **83305874.6**

(22) Date of filing: **29.09.83**

(54) Semiconductor memory device.

(30) Priority: **30.09.82 JP 171572/82**

(43) Date of publication of application:
**02.05.84 Bulletin 84/18**

(45) Publication of the grant of the patent:
**18.05.88 Bulletin 88/20**

(84) Designated Contracting States:
**DE FR GB**

(56) References cited:
**EP-A-0 218 739**
**US-A-3 732 440**

(73) Proprietor: **FUJITSU LIMITED**
**1015, Kamikodanaka Nakahara-ku**
**Kawasaki-shi Kanagawa 211 (JP)**

(72) Inventor: **Ooami, Kazuo**
**FUJITSU LIMITED, Patent Dpt. 1015**
**Kamikodanaka**
**Nakahura-ku Kawasaki 211 (JP)**
Inventor: **Sugo, Yasuhisa**
**FUJITSU LIMITED, Patent Dpt. 1015**
**Kamikodanaka**
**Nakahura-ku Kawasaki 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a semiconductor memory device.

In a bipolar RAM semiconductor memory device flip-flop circuitry has been provided external to the input stage of a RAM IC, for absorbing skew of time until bits which form address information appear. However, the device has a disappointing integration density, its manufacture is troublesome and its operational rate relatively poor, as a result of the external flip-flop circuitry.

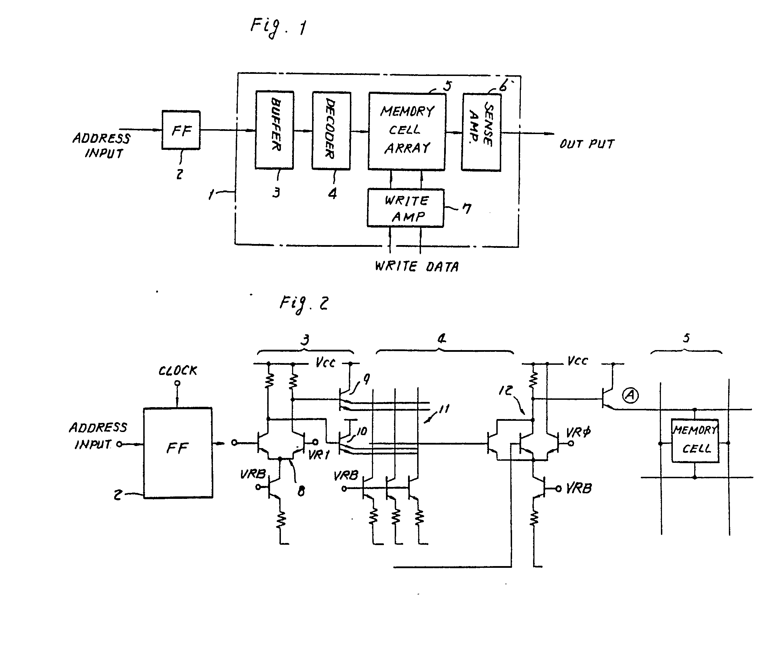

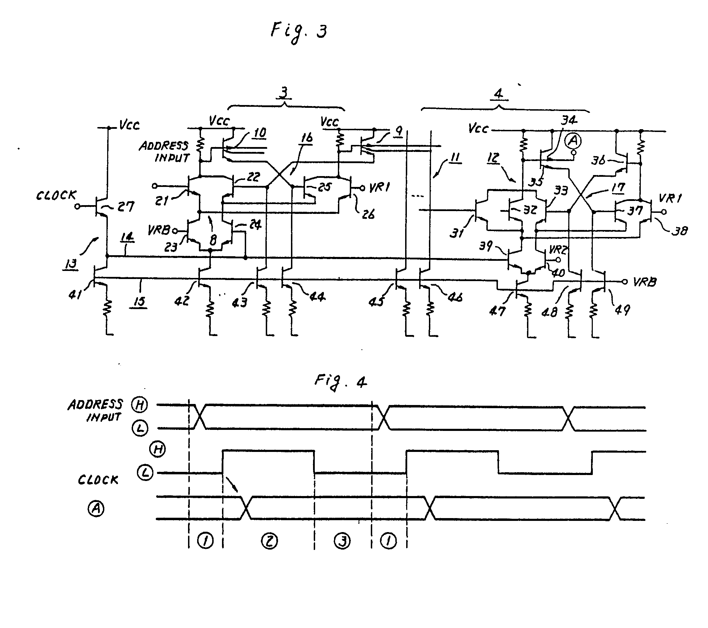

EP—A—0 018 739 discloses a bipolar RAM semiconductor memory device with circuitry similar to that illustrated in Figs. 1 and 2 of this application.

According to the present invention there is provided a semiconductor memory device, having an address input buffer and a decoder/driver comprising a decoder matrix, the device comprising flip-flop circuits for latching N-bit address information, said flip-flop circuits being provided in master-slave arrangements, whereby N master flip-flops are formed in the address input buffer and $2^N$ slave flip-flops are formed in the decoder/driver, and comprising a clock gate circuit, arranged to receive a clock signal, which controls the inputting of address information, thereby to absorb fluctuation of address information input timing, said flip-flop circuits being designed in such a way that:

(a) during a first timing period, when the clock input is at a first level, input address bits bring the master flop-flops into the corresponding states, which states are used by the decoder matrix for supplying selection signals to the slave flip-flops which however do not drive output lines of the decoder driver;

(b) during a second timing period, when the clock input goes to a second level, the state of the master flip-flops is not affected, but said selection signals supplied by the decoder matrix bring the slave flip-flops into the appropriate state, whereby their outputs drive the output lines of the decoder driver;

(c) during a third timing period, when the clock goes again to the first level, the state of the slave flip-flops is not affected, but the state of the master flip-flops corresponds to the address bits.

An embodiment of the present invention provides a semiconductor memory device using, for example, a bipolar RAM, wherein address holding flip-flop circuitry is comprised within the RAM IC.

An embodiment of the present invention provides a semiconductor memory device which comprises flip-flop circuitry internally of the integrated circuit of the device and which offers a higher operational rate by executing decoding in parallel by a decoder while a buffer circuit absorbs a skew of time until an address information appears. In the semiconductor memory device the decoder is provided between the master flip-flop and the slave flip-flop of a master slave type flip-flop.

Reference is made, by way of example, to the accompanying drawings, in which:—

Figure 1 is a schematic block diagram of a previously proposed semiconductor memory device,

Figure 2 is a more detailed circuit diagram of parts of the device of Figure 1,

Figure 3 is a circuit diagram showing principal parts of an embodiment of this invention, and

Figure 4 is a time chart for assistance in explanation of operation of the embodiment of Figure 3.

In Figure 1, 1 is a RAM IC circuit; 2 is an address holding flip-flop; 3 is a buffer circuit; 4 is a decoder; 5 is a memory cell array; 6 is a sense amplifier; and 7 is a write amplifier. Address information to be input to the RAM is first set in the flip-flop 2 in order to absorb skew between bits and the content of the flip-flop is supplied to the decoder 4 through the buffer 3.

Figure 2 shows in more detail main parts of the arrangement of Figure 1.

An address generally comprises a plurality of bits but in Figure 2 only one address bit is depicted, for clarity.

The one bit of address information to be input is synchronized with a clock input and is set in the flip-flop 2, the content of which is guided to a differential amplifier 8 of the buffer circuit 3. A true output and an inverted output provided from the differential amplifier 8 are supplied to a decoder matrix 11 of the decoder 4 through multi-emitter transistors 9 and 10 respectively. The result of selection by the matrix 11 is guided to logic 12 and drives a word drive line Ⓐ for an appropriate memory cell of the array 5.

In Figure 2, VRB, VR1, VRφ are voltage levels and Vcc is a voltage supply.

The previously proposed device has been constituted as explained above, but in an embodiment of the present invention, means corresponding to the flip-flop 2 of Figure 2 is comprised within the RAM IC circuit.

Figure 3 illustrates main parts of an embodiment of this invention. Reference numerals 3, 4, 8, 9, 10, 11, 12 refer to items similar to those designated by the same reference numerals in Fig. 2. VRB, VR1, VR2 are voltage levels and Vcc is a voltage supply. CLOCK is a clock input. Further, in Figure 3, 13 is a clock gate circuit, 14 is a control line, 15 is a reference voltage line, 16 and 17 are master and slave flip-flop circuits, 21 to 27 and 31 to 49 are transistors.

There are N master flip-flops 16 when the number of address bits to be handled is N, and there are total of $2^N$ slave flip-flops 17.

In substance, Figure 3 shows parts concerned with handling one address bit.

In Figure 3, the buffer circuit 3 forms the master part 16 of the master slave flip-flop, while the logic 12 of the decoder forms the slave part 17 of the master slave flip-flop, and switching of the master slave flip-flop is controlled by the clock gate circuit 13. Of course, the flip-flop 2 shown in Figure 2 can be omitted with the structure of Figure 3. Operation of the structure shown in Figure 3 will be explained with reference to the time chart of Figure 4, in which three timing periods, ①, ②, ③, occur.

(1) In timing period ① a clock input is at low level. When an address input is at high level, transistor 23 goes ON, and transistor 24 goes OFF, since the control line 14 is also at low level. Therefore, transistor 21 turns ON and transistors 22, 25, 26 turn OFF. The base voltage of transistor 10 becomes low, and the base voltage of transistor 9 high level, and this state is guided to the matrix 11 of decoder 4 through the emitter followers of transistors 10 and 9.

The matrix 11 of decoder 4 provides plurality of blocks such as, for example, one block which gives (handles) inputs A, $\overline{A}$, B, $\overline{B}$, one block which gives (handles) inputs C, $\overline{C}$, D, $\overline{D}$, ... etc. One block corresponds, for example, to the state of inputs A, B and only one of four output lines of the block becomes low (the other three lines are at high level) in correspondence to the four possible states "00", "01", "10", "11" of the inputs. The above-mentioned inputs A, $\overline{A}$ can be taken to correspond respectively to the output from the transistor 10 shown in Figure 3 and the output from the transistor 9, whilst the inputs B, $\overline{B}$ can be taken to correspond to outputs of further individual transistors corresponding to transistors 10 and 9 (corresponding to another address bit).

One of the four outputs from one block in the matrix 11 of decoder 4 is input to the base of transistor 31 shown in Figure 3. In addition, one of the four outputs from another block is input to the base of transistor 32 shown in Figure 3.

For simplification, it it is assumed that only two blocks are used, and only two transistors 31, 32 exist, in correspondence to the relevant blocks, in the logic 12 of decoder 4, only when the desired address is given are the base voltages of the two transistors 31 and 32 given a low state or level corresponding thereto.

When the desired address is given as explained above, the base voltages of transistors 31 and 32 are at low level, but the clock (CKL) is in at low level in above period ①. Therefore, the base voltage of transistor 39 is at low level and even when a signal appears at the bases of transistors 31 and 32, the base voltages of transistors 34 and 35 are not yet changed. From Fig. 3 it will be seen that a multi (two)-emitter transistor, equivalent to two transistors whose collectors and bases are coupled in common respectively, is used to constitute transistors 34 and 35. Namely, the word line shown at Ⓐ in Figure 4 is not yet driven.

(2) Timing period ②:
In this period, an address input is continusously at high level and the clock input becomes high level. Therefore, transistors 21, 23 go from ON to OFF, whilst the transistors 22, 24 become ON. However, the base voltages of transistors 10 and 9 do not change. That is, input levels set in period ① are applied to the bases of transistors 31, 32 in the logic 12 of decoder 4.

When the clock becomes high in period ②, transistor 39 becomes ON, transistors 31, 32 become OFF, transistor 38 becomes ON, and transistors 33, 37, 40 become OFF. Thereby, the base voltages of transistors 34, 35 become high, the base voltage of transistor 36 becomes low, and voltage at point Ⓐ of Figure 3 becomes high as shown by Ⓐ of Figure 4. Thus, a word drive line for a memory cell can be selected.

(3) Timing period ③:
In this period, the clock input is at low level and a desired address can be input. Namely, when the clock input returns to low level again, from its condition in period ②, transistor 33 becomes ON. When transistor 39 becomes OFF and transistor 40 becomes ON, transistor 37 becomes ON and transistor 38 becomes OFF. However, transistor 36 is continuously OFF, and the bases of transistors 34, 35 are continuously high and the point Ⓐ is also continuously high. Whatever value the address input takes in this period, transistor 39 is OFF and the condition of point Ⓐ does not change.

As explained above, when an address input is applied in Figure 3, a result of decoding of the pertinent address is held in a form in which it is latched to the input stage of logic 12 by the master slave flip-flops 16, 17.

In the above example, only the selection of a decoder line for word line driving is explained; it will be understood that similar steps can be taken in respect of a decoder for bit lines.

As explained above, in an embodiment of this invention, the result decoded from a given address input is held in such a manner that it is latched to the input stage of decoder logic 12 forming the master slave flip-flops. Therefore fluctuation of the address input can be absorbed (tolerated) during a period until a clock input is applied, and high speed operation can also be attained.

An embodiment of the present invention provides a semiconductor memory comprising flip-flops which hold input address information in order to absorb skew of address input within the same chip. A master slave flip-flop type arrangement is provided and an address decoder is provided between the master flip-flop and slave flip-flop. A part of the time required for latching an address signal to the master flip-flop and the part of the time required for decoder operation are overlapped and thereby a high operational speed can be achieved. Parts of the circuitry forming the master and slave flip-flops is used in common by an address input buffer and word line driver circuits.

An embodiment of the present invention can provide that address bits, arriving at different times, are latched and held for simultaneous presentation to the memory for parallel decoding.

**Claims**

1. A semiconductor memory device, having an address input buffer (3) and a decoder/driver (4) comprising a decoder matrix (11), the device comprising flip-flop circuits (16, 17) for latching N-bit address information, said flip-flop circuits being provided in mater-slave arrangements whereby N master flip-flops (16) are formed in the address input buffer (3) and $2^N$ slave flip-flops (17) are formed in the decoder/driver (4), and comprising a clock gate circuit (13), arranged to receive a clock signal, which controls the inputting of address information, thereby to absorb fluctuation of address information input timing, said flip-flop circuits being designed in such a way that:

(a) during a first timing period, when the clock input is at a first level, input address bits bring the master flip-flops into the corresponding states, which states are used by the decoder matrix for supplying selection signals to the slave flip-flops which however do not drive output lines of the decoder driver;

(b) during a second timing period, when the clock input goes to a second level, the state of the master flip-flops is not affected, but said selection signals supplied by the decoder matrix bring the slave flip-flops into the appropriate state, whereby their outputs drive the output lines of the decoder driver;

(c) during a third timing period, when the clock input goes again to the first level, the state of the slave flip-flops is not affected, but the state of the master flip-flops corresponds to the address bits.

2. A semiconductor memory device as claimed in claim 1, wherein the output lines of the decoder/driver are word lines of the memory device.

3. A semiconductor memory device as claimed in claim 1, wherein the output lines of the decoder/driver are bit lines of the memory device.

4. A semiconductor memory device as claimed in any preceding claim, being an IC memory device wherein the flip-flop circuits are formed internally of the memory IC.

**Patentansprüche**

1. Halbleiterspeichervorrichtung mit einem Adresseneingabepuffer (3) und einem Decoder/Treiber (4), der eine Decodermatrix (11) enthält, welche Vorrichtung Flip-Flop-Schaltungen (16, 17) zum Verriegeln der N-Bit-Adresseninformation umfaßt, welche Flip-Flop-Schaltungen in einer Mutter-Tochter-Anordnung vorgesehen sind, wodurch N Mutter-Flip-Flops (16) in den Adresseneingabepuffer (3) gebildet sind und $2^N$-Tochter-Flip-Flops (17) in dem Decoder/Treiber (4) gebildet sind, und mit einer Takttorschaltung (13), die angeordnet ist, um ein Taktsignal zu empfangen, welches das Eingeben der Adresseninformation steuert, um dadurch die Fluktuation der Adresseninformations-Eingabezeitsteuerung zu absorbieren, welche Flip-Flop-Schaltungen auf solche Weise ausgelegt sind, daß:

(a) während einer ersten Zeitsteuerperiode, wenn der Takteingang auf einem ersten Pegel ist, Eingangsadressenbits die Mutter-Flip-Flops in die entsprechenden Zustände setzen, welche Zustände von der Decodermatrix verwendet werden, um den Tochter-Flip-Flops Auswahlsignale zuzuführen, welche jedoch nicht Ausgangsleitungen für den Decodertreiber treiben;

(b) während einer zweiten Zeitsteuerperiode, wenn der Taktimpuls auf einen zweiten Pegel geht, der Zustand der Mutter-Flip-Flops nicht beeinflußt wird, jedoch die genannten Auswahlsignale, welche von der Decodermatrix geliefert werden, die Tochter-Flip-Flops in einen geeigneten Zustand setzen, wodurch ihre Ausgänge die Ausgangsleitungen des Decodertreibers treiben;

(c) während einer dritten Zeitsteuerperiode, wenn der Taktimpuls wieder auf den ersten Pegel geht, der Zustand der Tochter-Flip-Flops nicht beeinflußt wird, jedoch der Zustand der Mutter-Flip-Flops den Adressenbits entspricht.

2. Halbleiterspeichervorrichtung nach Anspruch 1, bei der die Ausgansleitungen des Decoders/Treibers Wortleitungen der Speichervorrichtung sind.

3. Halbleiterspeichervorrichtung nach Anspruch 1, bei der die Ausgangsleitungen des Decoder/Treibers Bitleitungen der Speichervorrichtung sind.

4. Halbleiterspeichervorrichtung nach einem der vorhergehenden Ansprüche, welche eine IC-Speichervorrichtung ist, in der Flip-Flop-Schaltungen innenhalb des Speicher-IC gebildet sind.

**Rendications**

1. Dispositif de mémoire à semiconducteur, comportant un tampon d'entrée d'adresse (3) et un décodeur/circuit de commande (4) comprenant une matrice de décodeur (11), le dispositif comprenant des circuits à bascule (16, 17) pour verrouiller des informations d'adresse à N bits, les circuits à bascule étant prévus dans des dispositions à maître-esclave, N bascules maîtresses (16) étant ainsi formées dans le tampon d'entrée d'adresse (3) et $2^N$ bascules esclaves (17) étant formées dans le décodeur/circuit de commande (4), et comprenant un circuit de déclenchement d'horloge (13), agencé pour recvoir un signal d'horloge, qui commande l'introduction des informations d'adresse, pour absorber de la sorte une fluctuation de synchronisation d'entrée d'informations d'adresse, les circuits à bascule étant conçus de telle manière que:

(a) pendant une première période de synchronisation, quand le signal d'horloge d'entrée est à un premier niveau, des bits d'adresse d'entrée mettent les bascules maîtresses aux états correspondants, ces états étant utilisés par la matrice de décodeur pour fournir des signaux de sélection aux bascules esclaves qui ne commandent pas, néanmoins, les lignes de sortie du décodeur/circuit de commande;

(b) pendant une deuxième période de synchronisation, quand le signal d'horloge d'entrée passe à un second niveau, l'état des bascules maîtresses n'est pas modifié, mais les signaux de sélection fournis par la matrice de décodeur mettent les bascules esclaves à l'état approprié, leurs signaux de sortie commandant ainsi les lignes de sortie du décodeur/circuit de commande;

(c) pendant une troisième période de synchronisation, quand le signal d'horloge d'entrée repasse au premier niveau, l'état des bascules esclaves n'est pas modifié, mais l'état des bascules maîtresses correspond aux bit d'adresse.

2. Dispositif de mémoire à semiconducteur selon la revendication 1, dans lequel les lignes de sortie du décodeur/circuit de commande sont des fils de mot du dispositif de mémoire.

3. Dispositif de mémoire à semiconducteur selon la revendication 1, dans lequel les lignes de sortie de décodeur/circuit de commande sont des fils de bit du dispositif de mémoire.

4. Dispositif de mémoire à semiconducteur selon l'une quelconque des revendications 1 à 3, qui est un dispositif de mémoire en circuit intégré CI dans lequel les circuits à bascule sont formés à l'intérieur de la mémoire en CI.

Fig. 1

ADDRESS INPUT → FF (2) → BUFFER (3) → DECODER (4) → MEMORY CELL ARRAY (5) → SENSE AMP. (6) → OUTPUT

WRITE AMP (7) ← WRITE DATA

Fig. 2

CLOCK

ADDRESS INPUT ○→ FF (2)

VRB  VR1  8

9  10  11

VRB

12  VRØ  VRB

Vcc  A

MEMORY CELL

WRITE DATA

Fig. 3

Fig. 4